Europäisches Patentamt

European Patent Office

Office européen des brevets

(11) Publication number: 0 396 522
A2

# EUROPEAN PATENT APPLICATION

(21) Application number: 90850153.9

(51) Int. Cl.⁵: H05K 3/40

(22) Date of filing: 24.04.90

(30) Priority: 05.05.89 US 347842

(43) Date of publication of application:
07.11.90 Bulletin 90/45

(84) Designated Contracting States:
DE FR GB

(71) Applicant: International Business Machines
Corporation
Old Orchard Road
Armonk, N.Y. 10504(US)

(72) Inventor: Frankeny, Jerome Albert
516 West 7th Street
Taylor, Texas 76574(US)

Inventor: Frankeny, Richard Francis
Route 4, Box 285
Elgin, Texas 78621(US)
Inventor: Hermann, Karl
12014 Sky West Drive
Austin, Texas 78758(US)
Inventor: Wustrau, Rolf
4300 Burney Drive
Austin, Texas 78731(US)

(74) Representative: Johansson, Lars E. et al
IBM Svenska AB, SW Intellectual Property
Dept.
S-163 92 Stockholm(SE)

(54) Universal electrical interconnection system and method.

(57) A carrier preferably in the form of a thin insulative and heat-resistant sheet (14) has a plurality of apertures (26) extending therethrough which are preloaded to carry a reflowable electrically conductive solder (28) or paste. Upon positioning the carrier between lands (18-24) of circuit carriers, printed circuit boards, combinations thereof or the like, predetermined electrical interconnections may be effected between such lands by reflow. The electrical interconnection is completed between given upper and lower such lands through the conductive material in a plurality of apertures disposed between the lands. In a preferred embodiment the aperture density relative to the area of the lands to be interconnected is selected to provide redundancy by permitting plural interconnections through apertures to a given land pair. Aperture diameter and amount of reflowable material present therein is further selected whereby upon such reflowing apertures between adjacent pads act as solder dams to prevent undesirable electrical interconnection between such adjacent pads. A system is provided whereby the carrier need not be precisely aligned relative to the land patterns and whereby necessity for precise screening of conductive material to accommodate fine pitch land/pad configurations is eliminated.

FIG. 1

## UNIVERSAL ELECTRICAL INTERCONNECTION SYSTEM AND METHOD

### Technical Field

This invention relates to electronic packaging systems and methods and, more particularly, relates to systems and methods for effecting electrical interconnections with multiple fine pitch land or pad configurations.

### Background Art

As the electronic packaging arts have progressed, the trend has been toward increased packaging density resulting in multi-layer packages and extremely fine pitched lands, pads, and circuit line configurations. Typical dimensions encountered are interconnect pads, pitches and widths of .020 and .10 inches respectively. ˙

This has in turn resulted in the need for systems and methods for effecting reliable and economic interconnections between these minute points which are disposed at multiple layers.

One such method for providing for the electrical interconnection between points on separate layers was to deposit by screening or other techniques well known in the art a solder or conductive paste on the finely spaced leads, lands, pads, or other desired interconnection points of one level of the package. By placing the second layer of the package, which typically might consist of a printed circuit board or the like, in vertical registry with the previously thus-coated first layer, which typically might be a flexible or solid circuit carrier, and by thereafter causing the solder or paste to be reflowed, the desired interconnection between the thus vertically aligned locations on the two layers could be effected. However, a serious problem with the aforementioned technique was the difficulty experienced in reliably depositing the reflowable conductive material on such finely spaced lands, pads, or the like. This was necessary to avoid shorts caused when the material bridged across points which were intended to be electrically isolated, thereby causing substantially increased manufacturing costs of waste or rework.

Accordingly, an improved system and method were highly soughtafter which provided a way to effect electrical interconnections between multiple layers of a high density electronic packaging system. Such a system and method is provided by the present invention wherein the need for accurate positioning of screened solder or other conductive paste on one or more layers of the multi-layer construction is obviated. Moreover the need to accurately position to increasingly demanding tolerances any interposing layer in precise vertical registry for connecting the desired points at the multiple layers is further eliminated.

### Summary of the Invention

The present invention is defined in the attached claims.

A system and method is provided for use in establishing electrical interconnections between conductive areas in an electronic circuit package. In a preferred embodiment, a carrier means defining a plurality of apertures therein is provided taking the form of a thin sheet or tape of an insulative, high temperature polymer. The apertures are substantially filled with an electrically conductive and reflowable material such as a solder or conductive paste.

In an electronic circuit package employing the hereinabove described carrier means pre-loaded with electrically conductive reflowable material, preselected pairs each comprised of a first and second location desired to be interconnected are disposed on respective circuit carriers, printed circuit boards, or the like, or combinations thereof, such locations taking the form of fine pitch lines, lands, or pads, as desired. In a preferred embodiment the apertures extend entirely through the carrier means whereby the conductive means carried within the apertures is thereby exposed on opposing sides of the carrier. The aperture pattern in the carrier is preselected whereby when the carrier is positioned between the plurality of pairs of first and second locations in any of a plurality of different orientations, and the conductive means is reflowed, it forms electrical interconnections whereby, for each such location pair, an electrical interconnection is formed from the first location through the conductive means in one or more of the apertures between the locations to the second location.

It is a feature of the invention that the aperture density in the carrier is preselected to be sufficiently high relative to the location areas whereby for a given first and second location pair, the electrical circuit will be completed between the locations of the pair through the conductive means disposed in a plurality of such apertures. In this manner redundancy is provided in establishing conductive paths through a plurality of apertures between a given location pair. Moreover, the aperture densities and diameters are further preselected whereby after reflowing, apertures and the conductive means therein lying between location pairs thereby interconnected by the reflowing remain electrically isolated from the interconnected pairs thereby avoiding electrical shorting of adjacent location pairs. By preselection of the amount of conductive material carried by such apertures disposed laterally between location pairs, these apertures not forming pair interconnections act as solder dams thereby preventing the aforementioned undesirable shorting out between adjacent location pairs.

It is a further feature of the invention that a universal carrier is thereby provided for effecting electrical interconnection between locations at multiple layers in an electronic circuit package. More particularly, the aperture pattern, density, and diameter is preselected whereby preselected ones of such interconnections between pairs of first and second locations may be established without substantial co-alignment of the patterns formed by the first and second locations and the apertures in the carrier means prior to said reflowing. Accordingly, the apertures are spatially posi tioned within the carrier sheet whereby preselected ones of the paired locations may be interconnected when the sheet is oriented in any of a plurality of positions between the circuit boards, circuit carriers or the like carrying the first and second locations. The particular ones of the apertures through which the electrical connections are completed for a given location pair are defined by which of the plurality of orientations the carrier assumes relative to the first and second locations.

Brief Description of the Drawings

The novel features believed to be characteristic of the invention are set forth in the appended claims. The invention itself, however, as well as other features and advantages thereof, will be best understood by reference to the following description of the preferred embodiment, when read in conjunction with the accompanying figures, wherein:

Fig. 1 is an exploded pictorial illustration of electronic package of the present invention;

Fig. 2 is an elevational view of the package depicted in Fig. 1 prior to reflowing;

Fig. 3 is another elevational view of the package depicted in Fig. 1 after reflowing;

Fig. 4 is an exploded pictorial view of an alternate embodiment of the package depicted in Fig. 1 illustrating an alternative carrier means;

Fig. 5 is another alternate embodiment of the package of Fig. 1 depicting another alternate embodiment of the carrier means.

Detailed Description of the Preferred Embodiment

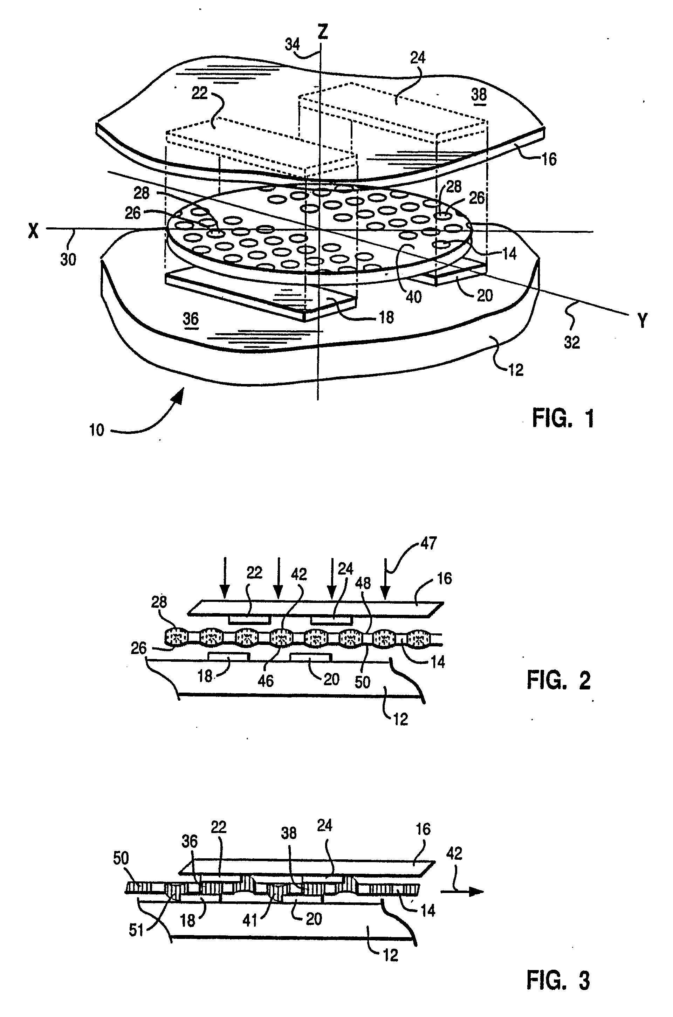

Referring first to Fig. 1, there will be seen depicted therein an illustrative electronic package 10 of the present invention. In one embodiment the package will be comprised of at least three layers comprising a first pad carrier 12, carrier means 14, and second pad carrier 16. It will be appreciated that the pad carriers 12 and 16 are generic terms for means for carrying conductive areas such as areas 18 and 20 and 22 and 24 with respect to carriers 12 and 16, respectively (such areas to be also hereinafter described in greater detail). Thus, these first and second pad carriers 12 and 16 may take a number of forms such as substrates, printed circuit boards, or the like well known in the art.

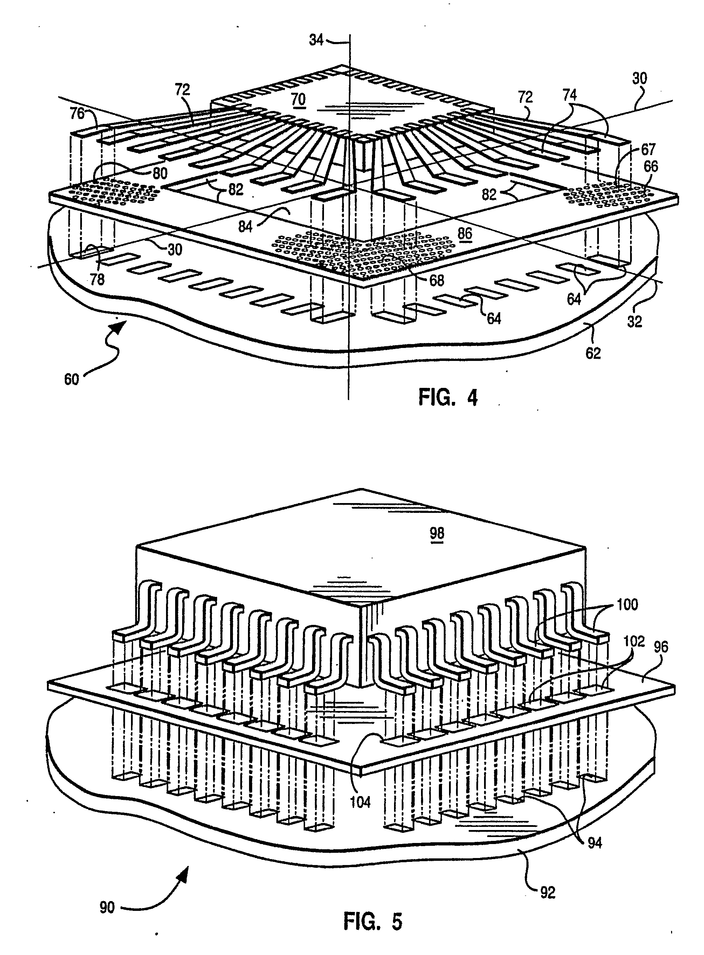

Still referring to Fig. 1 and, more particularly, to the aforementioned conductive areas, the first pad carrier 12 carries a plurality of such conductive areas (also referred to herein as first locations such as locations 18 and 20). In like manner, the conductive areas hereinafter also referred to as a plurality of second locations 22 and 24 are carried by the second pad carrier 16. It will be appreciated that as with the pad carriers, the term "conductive area" is again intended to be generic referring to pluralities of conductive locations on the surfaces of the first and second pad carriers 12 and 16. These areas may thus individually take the form of pads, lands, circuit lines or any other desired shapes or configurations such as those deposited on printed circuit boards, substrates, or the like in manners well known in the art. Although not depicted in Fig. 1 for purposes of clarity, these locations such as 18-24 will typically be electrically interconnected to other circuits on their respective carriers such as those shown in Figs. 4 and 5 comprising the desired electronic circuit, or may be connected to other discrete components by means of circuitized lines not shown on the various pad carriers.

For purposes of the invention it is important to note that it is frequently desired in the electronic packaging arts to provide for an electrical interconnective path between the various preselected pairs of these conductive areas or first and second locations which are disposed at respective differing elevations. More particularly, with respect to the first locations 18 and 20 and the second locations 22 and 24, it may be desired to form an electrical circuit by interconnecting the location pairs 18 and 22 and/or to form a similar electrical interconnection between location pairs 20 and 24. It will be recalled in the preceding discussion relative to background art that it was conventional, by some form of screening process or the like, to deposit a conductive paste or solder on surfaces of these locations 18-24, whereby when the first and second pad carriers 12 and 16 were brought into mating engagement and vertical registry and then the solder or conductive paste was reflowed, the desired electrical connections between locations 18-22 and/or 20-24 were thereby affected. However, due to the increasingly minute dimensions or surface areas of such locations, it became increasingly difficult to effectively insure that the solder or conductive paste was deposited as desired on the location surface areas without causing an undesired lateral short between a pair of locations on the first carrier 12, on the second carrier 16, or an undesired vertical short between a pair comprised of a location from the first and second carriers. It will be noted in passing that the pad carriers 12 and 16 are typically comprised of an insulative material whereas the first and second locations are typically comprised of a copper foil or the like.

Still referring to Fig. 1, the carrier means 14 is comprised of a thin insulative material. Disposed in the carrier means 14 is a plurality of apertures 26 which in one embodiment are aligned with their axes penetrating the plane 40 in which the carrier means 14 lies. Each of the apertures 26 will be filled by means of a screening process or other technique known in the art with a conductive means 28 such as a solder, conductive paste, or the like which is reflowable. It will be noted that in a preferred embodiment the first pad carrier 12 and first locations 18-20, etc. carried thereon will lie generally in a first plane 36, whereas the second pad carrier 16 and corresponding second locations 22-24, etc. will lie generally in a second plane 38 with the carrier means disposed therebetween, the planes 36, 38 and 40 being general ly parallel, with the Z axis 34 being normal to these planes and parallel to the axes of the apertures 26. The planes 36, 38 and 40 will further be seen in one embodiment to be parallel to the plane defined by the X and Y axes 30 and 32, respectively, which are normal to the Z axis 34.

It will be noted from Fig. 1 that it is a feature of the invention to provide the pattern of apertures 26 and conductive means 28 disposed therein in such a manner that when the first and second pad carriers 12 and 16 are brought together in a sandwich fashion a plurality of these apertures 26 are interposed between the surface areas defining each location pair. The purpose for this is to provide redundancy in the electrical interconnections through the apertures 26 to their respective location's conductive areas. This may be seen in more detail with respect to Figs. 2 and 3 which will now be discussed.

Referring to Fig. 2 which is a side view of the package 10 of Fig. 1 prior to reflowing. The apertures 26 preferably extend entirely through the carrier means 14 whereby outer surfaces such as 42 and 46 of conductive means 28 are thereby exposed on opposing surfaces 48 and 50 of the carrier means 14. To complete formation of the desired electronic package, the second pad carrier 16 is moved in the direction of the arrows 47 toward the first pad carrier 12 whereby the carrier means 14 contacts the lower surfaces of the second locations 22 and 24 disposed downwardly on the inner surface of the second pad carrier 16 and the upper surfaces of the upwardly extending first locations 18 and 22 carried on the inner upper surface of the first pad carrier 12. With the pad carriers 12 and 16 and carrier means 14 thus positioned, the conductive means 28 is thence reflowed as, for example, by raising the temperature by conductive heating, induction, or other techniques until the conductive means 28 reflows as shown in Fig. 3. When this occurs, the conductive means such as that indicated by reference numerals 36 and 38 bonds, respectively, to first and second pad pairs 18-22 and 20-24 thereby forming the electrical interconnection 18-36-22 or 20-38-24. In that the views of Figs. 2 and 3 are cross-sections of the package 10 it will be appreciated that a plurality of additional such interconnections through different apertures not shown will be made between the location pairs 18-22, 20-24, etc. as well as through additional location pairs wherein the locations are spaced about on the carriers 12, 16 as desired.

One feature of the invention which may be noted with reference to Fig. 3 is that due to the relative patterns of the apertures 26 and the first and second locations on the first and second respective pad carriers 12 and 16, conductive means such as that shown at reference numerals 41 and 50 may contact only one or no locations thereby not completing an electrical circuit between first and second pad carriers 12 and 16.

Moreover, another important feature of the present invention may be seen with reference to Fig. 3. Because of the redundant aperture pattern formed in the carrier means 14 as well as the cross-sectional area of the apertures and conductive means thereby exposed relative to the surface area and position of the various first and second locations, the desired electrical interconnections between, for example, location pairs 18-22 and 20-24 may be effected while maintaining electrical isolation between such location pairs regardless of the relative orientation of the carrier means 14 in the plane 40 in the X-Y axes 30-32.

More specifically, for example, if the carrier means 14 had been moved in the direction of the arrow 42 in Fig. 3, rotated with respect to the Z axis 34 in Fig. 1, or otherwise oriented in any of a plurality of different orientations in the plane 40 of Fig. 1 prior to reflowing, the desired electrical interconnections between locations 18-22 and 20-24 would nevertheless be effected through different apertures 26. In this manner, a system and method has been provided for effecting the desired electrical interconnection between preselected first and second locations without the necessity for precisely aligning the carrier means 14 relative to the patterns formed by the first and second locations and without the necessity for precisely screening or otherwise positioning conductive material on the faces of the first and/or second locations prior to reflowing to effect the desired interconnections.

With reference to Fig. 3 yet additional features of the invention may be seen illustrated therein. First, even though the first locations such as 18 and 20 are not in exact vertical registry with corresponding second locations such as 22 and 24, the desired electrical interconnection between locations 18-22 and 20-24 are nevertheless effected. This is due to the preselected aperture density in the carrier means 14 being sufficient relative to the surface area of the conductive areas of the location pairs such as that if the first and second pad carriers 12 and 14 are misaligned conductive material in different ones of the apertures will nevertheless effect the desired interconnections between location pairs.

Thus, for example, if the second pad carrier 16 were displaced slightly to the left of the position shown in Fig. 3, interconnection between locations 18-22 might nevertheless be effected by the conductive material in aperture 51. This feature is of significant benefit in reducing manufacturing cost of the package whereby, by means of the invention, not only is it unnecessary to precisely align the pad carriers 12 and 16 but it is further unnecessary to precisely align the carrier means 14 with respect to the pad carriers 12 and 16. It will be further noted from Fig. 3 that the aperture density, diameter and placement is preselected whereby at least a portion of the conductive means in some of the apertures (such as those shown at reference numerals 41 and 50) are either electrically isolated from all first and second locations (as in the case of reference numeral 50) or are only in contact with a first or second location but not both (as in the case of reference numeral 41).

In Fig. 4 an alternate package 60 is shown again having a first pad carrier 62 carrying first location conductive areas 64 on the surface thereof (in the form of pads, circuit lines, lands, etc. as desired). The package 60 may be further seen to include a carrier means 66 with a plurality of apertures 67 disposed therethrough carrying the aforementioned conductive means, and finally a second pad carrier 70 including a plurality of second locations 74 (also, as desired, in the form of pads, lands, or the like). The second carrier (and/or first carrier) may include one or more chips or other circuitry as desired as well as leads 72 electrically interconnecting the chip or other circuitry to the suitable second locations 74 or 76.

With reference in more detail to the alternate embodiment of the carrier means 66 shown in Fig. 4, in this embodiment inner surfaces 82 define an inner area 84 which has been removed from the sheet comprising the carrier means 66. Nevertheless, sufficient aperture density is provided in the carrier means 66 whereby electrical interconnections may be effected, for example, between first and second location pairs 76-78 through apertures 80 or between location pairs 64-74 through apertures 67 even though the first and second carriers 62, 70 may not be perfectly aligned in vertical registry and/or the carrier means 66 is, in like manner, not perfectly vertically aligned relative to the first and/or second locations. Accordingly, as with the previously described embodiment, the desired preselected location pair interconnections may be effected even with substantial misalignment of the first and second carriers 62 and 70 and carrier means 66 by relative mispositioning in either direction along axis 30, 32 or in some other fashion in the plane defined thereby including misalignment caused by translation of one or more of the carriers about the vertical axis 34. The alternate embodiment of Fig. 4 serves to illustrate that whereas a convenient form of the carrier means 66 takes the form of a sheet or tape, the invention is not intended to be so limited and may include a layer forming any geometric pattern as desired dependent upon the patterns formed by the first and second location pairs to be electrically interconnected, so long as apertures are disposed in the carrier means 66 so as to be positioned between each of the desired location pairs for effecting the interconnection upon reflowing.

In Fig. 5 yet an additional alternate embodiment of the packaging 90 is shown, again having first and second pad carriers 92 and 98 and carrier means 96 disposed therebetween. Again, the first carrier 92 has a plurality of conductive areas in the form of pad locations 94 and the second carrier 98, which is in the form of an integrated circuit chip, in like manner has a plurality of second locations 100 in the form of leads exiting the chip 98, the distal ends thereof defining the conductive areas comprising the second locations 100.

With respect to the carrier means 96, the apertures extending therethrough and carrying the conductive means form a plurality of patterns 102. The embodiment of Fig. 5 illustrates that not only may the geometric pattern of the carrier means 66 be formulated in a variety of geometric patterns as desired and dictated by the application (as in the case of Fig. 4), but also the pattern formed by the apertures themselves extending through the carrier means 96 may be varied in a variety of manners as desired so long as sufficient apertures are provided whereby they may be disposed adjacent desired ones of the first and/or second locations 94, 100 prior to reflowing so as to effect electrical interconnection between the conductor means disposed in the apertures and the desired ones of the first and/or second locations.

Thus, in the case of the embodiment of Fig. 5, these apertures form a plurality of square or rectangular shapes with spaces 104 therebetween each shape being comprised of a plurality of apertures filled with reflowable conductive material.

Although as previously indicated the spacing and size of the apertures is preselected so as to avoid electrical shorting from one location pair to an adjacent location pair or a first or second location thereof due to misalignment, in the case of the embodiment of Fig. 5 yet additional assurance is provided that no such undesired shorting occurs by providing for the space 104. However, due to the redundant number of apertures provided with respect to each location pair, electrical interconnection is nevertheless completed with respect to each location pair through a plurality of apertures as in the case of the previously discussed embodiments.

In a typical embodiment of the invention the following characteristics, materials, and dimensions may be employed:
Carrier means material:
High temperature polymer film such as that sold under the commercial trademark Kapton H, available from the Polymer Products Dept. Industrial Films Division, of the Dupont Company, Wilmington, Delaware
Aperture pattern in carrier means:
5 mil diameter holes on 8 mil centers typical distributed uniformly and formed by laser punch, etching, or other techniques well known in the art.
Conductive means:
Solder paste as used typically for screening onto standard surface mount technology pads such as RMA 12-12 having a 63% tin, 37% lead resin based flux composition available from the Alphametals, Inc., Company, Jersey City, N.J.

## Claims

1. An electronic circuit device for interconnecting conductive areas (18-24) comprising
a carrier means (14) defining a plurality of apertures (26) therein; and
electrically conductive means (28) carried in said apertures for establishing said interconnections when said conductive means is reflowed.

2. The device of Claim 1 wherein said conductive means is solder.

3. The device of Claim 1 wherein said conductive means is a conductive paste.

4. The device of Claim 1 wherein said carrier means is a sheet; and wherein said apertures extend through the sheet to expose the conductive means on opposing sides of the sheet.

5. The device of Claim 1 or 4 whereby upon said reflowing of the conductive means, said exposed conductive means in a first portion of the apertures contacts the conductive areas on both said opposing sides of the sheet, thereby forming said interconnection from the conductive areas through said first portion of apertures, and whereby upon said reflowing of the conductive means, said exposed conductive means in a second portion of the apertures is electrically isolated from contact with said conductive areas on said both opposing sides of the sheet.

6. The device of Claim 1 wherein said carrier means is electrically insulative.

7. The article of Claim 1 wherein said apertures are spaced apart in an amount sufficient that after said reflowing and establishing of electrical connections, said conductive means in at least one of the apertures remains electrically isolated from the conductive means in an adjacent at least one of the apertures.

8. The device of Claim 4 wherein said conductive areas comprise a plurality of paired areas each area of a given pair being disposed on a corresponding different opposing side of the carrier means; and wherein the apertures are spatially positioned within the sheet whereby preselected ones of said paired areas may be interconnected when the sheet is oriented in any of a plurality of positions in a plane defined by the sheet when extending between said preselected paired areas and when said conductive means is thence reflowed.

9. The device of Claim 1 wherein said conductive areas comprise first and second areas each defining a respective pattern; and wherein the apertures define a pattern in the carrier means whereby preselected ones of said interconnections may be established without substantial co-alignment of said patterns of the areas and the carrier means prior to the reflowing.

10. An electronic circuit package (10) comprising
a plurality of first pads (18, 20);
a plurality of second pads (22, 24);
a carrier means (14) disposed between said first and second pads defining a plurality of apertures (26) therethrough each containing a reflowable electrically conductive material (28); and
a plurality of pre-selected electrical connections electrically isolated from each other, each said connection being comprised of
one of said first pads;
one of said second pads; and
said conductive material in at least one of said apertures electrically interconnecting said one first and said one second pads.

11. The apparatus of Claim 10 wherein said first and second pads and the carrier means lie substantially along three respective parallel planes, and wherein the carrier means is disposed between the first and second pads.

12. The apparatus of Claim 10 or 11 wherein the apertures are holes extending through the carrier means and having axes extending through the planes.

13. The apparatus of Claim 10 wherein said conductive material in a portion of said plurality of apertures is electrically isolated from said connections.

14. The apparatus of Claim 11 wherein the carrier means is positionable at different orientations relative to said first and second pads; and the apertures define a pattern in the carrier means preselected whereby the connections are completed irrespective of said orientations.

15. A method for establishing electrical paths in an electronic circuit package between pairs of first and second locations defined on respective first and second planes, comprising
locating said first and second locations with said first and second planes in parallel orientation;
disposing a carrier having a plurality of apertures therein each carrying reflowable electrically conductive material between said first and said second planes; and
reflowing the conductive material until, with respect to each location pair, in at least one of the apertures between first and second locations comprising each said pair, the conductive material electrically contacts said each first and second location, thereby forming an electrical circuit between said each first and second location and through said at least one of the apertures.

16. A method for making an electronic circuit package for use in establishing preselected electrical interconnections, comprising
disposing a plurality of first locations in a first package layer defining a first preselected pattern;
disposing a plurality of second locations in a second package layer defining a second preselected pattern wherein it is desired to electrically interconnect each of said first locations with a corresponding preselected second location;
disposing a plurality of apertures defining an aperture pattern in a third package layer between said first and said second package layers; and
filling said apertures with an electrically conductive reflowable material, wherein the aperture pattern is preselected whereby with respect to each said first location and corresponding preselected second location, the preselected electrical interconnection may be established through said conductive material in different ones of the apertures, said different ones of the apertures being dependent upon orientation of the aperture pattern relative to said first and second patterns.

**FIG. 1**

**FIG. 2**

**FIG. 3**

FIG. 4

FIG. 5